(19) **Europäisches Patentamt / European Patent Office / Office européen des brevets**

(11) **EP 4 717 801 A1**

(12) **EUROPEAN PATENT APPLICATION**
published in accordance with Art. 153(4) EPC

(43) Date of publication:
01.04.2026 Bulletin 2026/14

(21) Application number: 24838467.9

(22) Date of filing: 23.05.2024

(51) International Patent Classification (IPC):
$C30B\ 23/02^{(2006.01)}$ $C30B\ 23/06^{(2006.01)}$

(52) Cooperative Patent Classification (CPC):
C04B 41/87; C04B 41/89; C30B 23/02;
C30B 23/06; C30B 25/18; C30B 27/00; C30B 29/36

(86) International application number:
PCT/CN2024/094999

(87) International publication number:
WO 2025/011209 (16.01.2025 Gazette 2025/03)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 07.07.2023 CN 202310837065

(71) Applicant: SICC (Shanghai) Semiconductor
Materials Co., Ltd.
Shanghai 201306 (CN)

(72) Inventors:
• SUI, Xiaoming
Shanghai 201306 (CN)
• MA, Lixing
Shanghai 201306 (CN)
• LIU, Shuo
Shanghai 201306 (CN)
• WANG, Lifeng
Shanghai 201306 (CN)
• LIU, Jiapeng
Shanghai 201306 (CN)
• WANG, Kunpeng
Shanghai 201306 (CN)
• ZHANG, Lin
Shanghai 201306 (CN)
• YANG, Heng
Shanghai 201306 (CN)
• WANG, Yinghui
Shanghai 201306 (CN)

(74) Representative: Huang, Liwei
Cäcilienstraße 12
40597 Düsseldorf (DE)

(54) **SILICON CARBIDE SUBSTRATE HAVING STEPWISE STRESS DISTRIBUTION**

(57) The present application relates to the technical field of silicon carbide production and processing, and discloses a silicon carbide substrate having a stepwise stress distribution. The silicon carbide substrate comprises a first main surface and a second main surface; the first main surface is provided with a first gradient stress region, a second gradient stress region surrounding the first gradient stress region, and a third gradient stress region surrounding the second gradient stress region, the width of the third gradient stress region extending inwards from the edge of the substrate is 2.5-30 mm, and the width of the second gradient stress region extending inwards from the edge of the third gradient stress region is 10-50 mm; the relative internal stress of the first gradient stress region is greater than or equal to the relative internal stress of the second gradient stress region and smaller than the relative internal stress of the third gradient stress region. The relative internal stresses of different regions of the silicon carbide substrate transition uniformly, and a stepwise distribution is realized, such that the quality of the silicon carbide substrate can be improved, and the use range of the silicon carbide substrate is expanded.

FIG. 3

EP 4 717 801 A1

## Description

### CROSS-REFERENCE TO RELATED APPLICATIONS

The present application claims the benefit of priority of Chinese Patent Application No. 202310837065.0, filed with the China National Intellectual Property Administration on July 7, 2023, and titled "SILICON CARBIDE SUBSTRATE HAVING STEPWISE STRESS DISTRIBUTION", the entire content of which is incorporated herein by reference.

### TECHNICAL FIELD

The present application relates to the technical field of silicon carbide production and processing, and in particular to a silicon carbide substrate having a stepwise stress distribution.

### BACKGROUND

Silicon carbide (SiC) single crystal substrates have become the preferred semiconductor materials for preparing GaN-based high-frequency microwave devices due to their excellent physical properties such as large band gap width, high resistivity and thermal conductivity, and high breakdown field strength. With the continuous development of 5G technologies, the market demand for SiC single crystal substrates is growing in volume. More importantly, large-scale commercial applications has also imposed higher quality requirements for SiC single crystal substrates.

During the growth of SiC crystals, defects such as polycrystalline, polymorphism, micropipes, and dislocations are easily introduced into the crystals due to factors such as Si/C ratio imbalance, introduction of impurities, and temperature gradient changes. These defects will cause lattice distortion, or more seriously, crystal transformation, such as intergrowth of multiple crystal forms including 4H, 6H, 3C, and 15R. Lattice distortion will release stress by the generated defects, that is to say, introducing internal stress into SiC, thereby reducing the quality of SiC crystals, limiting their use range, and bringing down the yield rate. Moreover, the presence of temperature fields or defects tends to cause uneven distribution of the internal stress of the SiC substrate, which affects the production and processing of downstream products.

### SUMMARY

In order to solve the above-mentioned problems, the present application provides a SiC substrate having a stepwise stress distribution. The SiC substrate has a first gradient stress region, a second gradient stress region, and a third gradient stress region. The relative internal stress in each zone is uniformly transitioned, achieving a stepwise distribution, which can improve the quality of the SiC substrate and expand its use range. The SiC substrate can be processed into an epitaxial wafer, or used as a seed crystal for crystal growth, to reduce the stress of the epitaxial wafers or crystal, to obtain a high-quality epitaxial wafer or crystal.

According to one aspect of the present application, a SiC substrate having a stepwise stress distribution is provided. The diameter of the SiC substrate is 150 mm or greater, and the SiC substrate includes a first main surface and a second main surface;

the first main surface has a first gradient stress region, a second gradient stress region surrounding the first gradient stress region, and a third gradient stress region surrounding the second gradient stress region; the width of the third gradient stress region, which is measured inward from the edge of the substrate, is 2.5 mm to 30 mm, and the width of the second gradient stress region, which is measured inward from the inner edge of the third gradient stress region, is 10 mm to 50 mm; and

a relative internal stress in the first gradient stress region is greater than or equal to a relative internal stress in the second gradient stress region, and the relative internal stress in the first gradient stress region is less than the relative internal stress in a third gradient stress region, in which the relative internal stress is a stress value detected at a position which is at least 3 $\mu$m deep measured perpendicularly from the first main surface or second main surface into the SiC substrate.

The relative internal stress in the second gradient stress region is the minimum, and the relative internal stress in the third gradient stress region is the maximum. Therefore, the greater the width of the second gradient stress region measured inward from the inner edge of the third gradient stress region is, the larger the proportion of the zone with less relative internal stress of the SiC substrate is.

Since the SiC crystal grows in a crucible, the periphery of the SiC crystal will contact the graphite crucible. In the high temperature environment of crystal growth, the graphite crucible will expand due to heat, and will squeeze the edge of the SiC crystal, generating an edge stress, which tends to cause lattice distortion, thus generating a stress. After the SiC substrate is obtained by processing the SiC crystal, the stress in the third gradient stress region of the substrate is the greatest among all stresses, and the first gradient stress region is the center area of the crystal. Due to the radial temperature gradient during SiC crystal growth, which shows a trend of increasing from the center to the edge, generally, the relative stress gradually increases from the center to the edge. As a result, the stress exhibits a gradually increasing tendency from the center to the edge, and the stress in the first gradient stress region is greater than that in the second gradient stress region.

Optionally, an absolute internal stress in the second gradient stress region is greater than or equal to an absolute internal stress in the first gradient stress region and less than an absolute internal stress in the third gradient stress region, in which the absolute internal stress is a stress value detected at a position which is at least 3 $\mu$m deep measured perpendicularly from the first main surface or the second main surface into the SiC substrate; and

According to the different processing states of the SiC substrate, the absolute and relative internal stresses are the stress values detected at least 3 $\mu$m deep measured perpendicularly from the first main surface or the second main surface into the SiC substrate. This method can ensure that the obtained stress values are the internal stress values of the SiC substrate, eliminating the stresses introduced during the SiC substrate machining processes such as cutting, grinding, and polishing.

Optionally, at any plane parallel to the first main surface and/or the second main surface, the radial absolute internal stress value in the first gradient stress region is from -20 MPa to 5 MPa, the radial absolute internal stress value in the second gradient stress region is from 5 MPa to 15 MPa, and the radial absolute internal stress value in the third gradient stress region is from 15.2 MPa to 50 MPa.

Optionally, at any plane parallel to the first main surface and/or second main surface, the radial absolute internal stress value in the first gradient stress region is from -5 MPa to 5 MPa, the radial absolute internal stress value in the second gradient stress region is from 5 MPa to 10 MPa, and the radial absolute internal stress value in the third gradient stress region is from 15.2 MPa to 20 MPa.

The tensile or compressive stress in the SiC substrate will cause expansion or contraction of the interplanar spacing d correspondingly, and the Raman peak will shift toward low frequency or high frequency accordingly when Raman spectroscopy is used for stress testing. When the substrate is subjected to the tensile stress inside, the Raman peak shifts toward low frequency, and the obtained stress value is positive. When the substrate is subjected to the compressive stress inside, the Raman peak shifts toward high frequency, and the obtained stress value is negative. Therefore, the positive and negative signs before the stress value in the present application represent the force direction inside the substrate, and the absolute value represents the magnitude of stress. For example, if the average absolute internal stress of the SiC substrate in the first gradient stress region is -3 MPa and the average absolute internal stress of the second gradient stress region is 5 MPa, the absolute internal stress in the first gradient stress region is a compressive stress, the absolute internal stress in the second gradient stress region is a tensile stress, and the radial absolute internal pressure in the first gradient stress region is less than the radial absolute internal pressure in the second gradient stress region.

According to the radial absolute internal stress values in the first gradient stress region, the second gradient stress region, and the third gradient stress region mentioned above, the first gradient stress region is a transition area between compressive stress and tensile stress, and the second gradient stress region and the third gradient stress region are both areas under tensile stress. The closer the stress value in the first gradient stress region or third gradient stress region is to that in the second gradient stress region, the more uniform the radial internal stress distribution of the SiC substrate is.

Optionally, when axial testing is performed perpendicularly from any point on the first main surface into the SiC substrate, the axial absolute stress value in the first gradient stress region is from -30 MPa to 10 MPa, the axial absolute stress value in the second gradient stress region is from 10 MPa to 30 MPa, and the axial absolute stress value in the third gradient stress region is from 30.2 MPa to 50 MPa.

The reference value of absolute stress in the present application is the reference stress calculated at the standard Raman peak position obtained based on perfect SiC lattice parameters, denoted as 0.

Optionally, at any plane parallel to the first main surface and/or second main surface, the radial relative internal stress value in the first gradient stress region is from -15 MPa to 15 MPa, the radial relative internal stress value in the second gradient stress region is from -10 MPa to 10 MPa, and the radial relative internal stress value in the third gradient stress region is from -24.8 MPa to 24.8 MPa.

Optionally, the radial relative internal stress value in the first gradient stress region is from -14.3 MPa to 14.5 MPa, and the radial relative internal stress value in the second gradient stress region is from -9.4 MPa to 10.0 MPa.

The radial absolute internal stresses mentioned above can reflect the difference between the substrate and a substrate with no residual internal stress (namely, a perfect crystal), and radial relative internal stresses can reflect the uniformity and distribution law of the substrate in the radial direction.

Optionally, at any plane parallel to the first main surface and/or second main surface, $S_{max1}$ represents the

maximum absolute value of the radial relative internal stress in the first gradient stress region, $S_{max2}$ represents the maximum absolute value of the radial relative internal stress in the second gradient stress region, and $S_{max3}$ represents the maximum absolute value of the radial relative internal stress in the third gradient stress region, in which $\Delta S1 = S_{max1} - S_{max2}$, $\Delta S2 = S_{max3} - S_{max1}$, and $\Delta S1 \leq \Delta S2$; and

optionally, 0 MPa $\leq \Delta S1 \leq$ 10 MPa, and 0 MPa $\leq \Delta S2 \leq$ 22 MPa.

Optionally, 0.2 MPa $\leq \Delta S1 \leq$ 9.8 MPa, and 0.3 MPa $\leq \Delta S2 \leq$ 21.4 MPa.

Optionally, at any plane parallel to the first main surface and/or second main surface, $S_{min1}$ represents the minimum absolute value of the radial relative internal stress in the first gradient stress region, $S_{min2}$ represents the minimum absolute value of the radial relative internal stress in the second gradient stress region, and $S_{min3}$ represents the minimum absolute value of the radial relative internal stress in the third gradient stress region, in which $\Delta S3 = S_{min1} - S_{min2}$, $\Delta S4 = S_{min3} - S_{min1}$, and $\Delta S3 \leq \Delta S4$; and

optionally, 0 MPa $\leq \Delta S3 \leq$ 5 MPa, and 0 MPa $\leq \Delta S4 \leq$ 20 MPa.

Optionally, 0.2 MPa $\leq \Delta S3 \leq$ 4.7 MPa, and 0.3 MPa $\leq \Delta S4 \leq$ 19.6 MPa.

Each of the absolute values of radial relative internal stress represents the magnitude of the relative stress in the corresponding zone. $\Delta S1$ and $\Delta S3$ represent the difference in the radial relative internal stress between the second gradient stress region and the first gradient stress region. The smaller the values of $\Delta S1$ and $\Delta S3$ are, the closer the radial relative internal stress in the second gradient stress region and that in the first gradient stress region are. $\Delta S2$ and $\Delta S4$ represent the difference in the radial relative internal stress difference between the third gradient stress region and the first gradient stress region. The smaller the values of $\Delta S2$ and $\Delta S4$ are, the closer the radial relative internal stress in the third gradient stress region and that in the first gradient stress region are. When $\Delta S1 \leq \Delta S2$ and $\Delta S3 \leq \Delta S4$, the difference in the radial relative internal stress of the SiC substrate between the second gradient stress region and the first gradient stress region is smaller than that between the third gradient stress region and the first gradient stress region.

Optionally, at any plane parallel to the first main surface and/or second main surface, S1 represents the average absolute value of the radial relative internal stress in the first gradient stress region, S2 represents the average absolute value of the radial relative internal stress in the second gradient stress region, and S3 represents the average absolute value of the radial relative internal stress in the third gradient stress region, in which 0 MPa $\leq$ S1 - S2 $\leq$ 14.5 MPa and 0 MPa $\leq$ S3 - S1 $\leq$ 22.5 MPa.

Optionally, 0 MPa $\leq$ S3 - S1 $\leq$ 22.4 MPa.

The SiC substrate is subjected to multi-point stress testing, and each of the average absolute values mentioned above is calculated by dividing the sum of the absolute stress values at all the testing points in the corresponding zone by the number of the testing points. This multi-point testing can be performed by selecting multiple points at different positions in the corresponding zone, or by mapping on the substrate.

Optionally, 0 MPa $\leq$ S1 - S2 $\leq$ 8 MPa, and 0 MPa $\leq$ S3 - S1 $\leq$ 10 MPa.

Optionally, when axial testing is performed perpendicularly from any point on the first main surface into the SiC substrate, the axial relative stress value in the first gradient stress region is from -20 MPa to 20 MPa, the axial relative stress value in the second gradient stress region is from -16 MPa to 16 MPa, and the axial relative stress value in the third gradient stress region is from -25 MPa to 25 MPa.

Optionally, the axial relative stress value in the first gradient stress region is from -19.3 MPa to 19.7 MPa, the axial relative stress value in the second gradient stress region is from -15.7 MPa to 15.2 MPa, and the axial relative stress value in the third gradient stress region is from -24.3 MPa to 24.7 MPa.

Axial absolute stresses can reflect the difference between the substrate and a substrate with no internal stress, and axial relative stresses can reflect the uniformity of the substrate in the axial direction.

In the present application, the radial relative internal stress at a testing point in the first gradient stress region is calculated with a numerical method based on the value of stress at the testing point and a reference value that is selected from some values by taking the first gradient stress region as a whole. The reference value can be selected from the group including but not limited to the average, median, and modal number of all the stress values across the entire testing plane, as well as the results calculated by using other statistical functions. Similarly, the radial relative internal stresses in the second gradient stress region and third gradient stress region are calculated in the same way.

The reference values of the radial absolute internal stresses in the first gradient stress region, the second gradient stress region, and the third gradient stress region are the reference stresses calculated at the standard Raman peak position obtained according to perfect SiC lattice parameters, denoted as 0.

Optionally, when axial testing is performed perpendicularly from any point on the first main surface into the SiC substrate, $S_{max5}$ represents the maximum axial relative internal stress in the first gradient stress region, and $S_{min5}$ represents the minimum axial relative internal stress in the first gradient stress region, in which $\Delta S5 = S_{max5} - S_{min5}$, and 0 MPa $\leq \Delta S5 \leq$ 10 MPa.

Optionally, 0 MPa $\leq \Delta S5 \leq$ 9.6 MPa.

$S_{max6}$ represents the maximum axial relative internal stress in the second gradient stress region, and $S_{min6}$ represents the minimum axial relative internal stress in the second gradient stress region, in which $\Delta S6 = S_{max6} - S_{min6}$, and

$0 \text{ MPa} \leq \Delta S6 \leq 10 \text{ MPa}$.

Optionally, $0 \text{ MPa} \leq \Delta S6 \leq 9.2 \text{ MPa}$.

$S_{max7}$ represents the maximum axial relative internal stress in the third gradient stress region, and $S_{min7}$ represents the minimum axial relative internal stress in the third gradient stress region, in which $\Delta S7 = S_{max7} - S_{min7}$ and $0 \text{ MPa} \leq \Delta S7 \leq 10 \text{ MPa}$.

Optionally, $0 \text{ MPa} \leq \Delta S7 \leq 9.9 \text{ MPa}$.

The maximum and minimum axial relative internal stresses mentioned above are the true values of axial internal stress, and are used to distinguish compressive stresses and tensile stresses in the axial direction. For example, on any axis, if the axial relative internal stress in the first gradient stress region is from -5 MPa to 1 MPa, the maximum axial relative internal stress is 1 MPa, the minimum axial relative internal stress is -5 MPa, and $\Delta S5$ is 6 MPa. $\Delta S5$, $\Delta S6$, and $\Delta S7$ represent the degree of change in the axial interplanar spacing of the substrate at a microscopic level. The smaller the values of $\Delta S5$, $\Delta S6$, and $\Delta S7$ are, the smaller the change in the axial interplanar spacing of the substrate is.

Optionally, $0 \text{ MPa} \leq \Delta S5 \leq 5.2 \text{ MPa}$, $0 \text{ MPa} \leq \Delta S6 \leq 3.9 \text{ MPa}$, and $0 \text{ MPa} \leq \Delta S7 \leq 6.1 \text{ MPa}$.

Optionally, the diameter of the SiC substrate is greater than 200 mm, the width of the third gradient stress region, which is measured inward from the edge of the substrate, is 21 mm to 30 mm; the width of the second gradient stress region, which is measured inward from the inner edge of the third gradient stress region, is 10 mm to 39 mm; and/or the thickness of the SiC substrate is not less than 0.1 mm.

Optionally, the deflection angle of the first main surface and/or second main surface relative to the {0001} plane is less than 4°.

Optionally, the bow of the SiC substrate is -50 $\mu$m to 50 $\mu$m.

Optionally, the bow of the SiC substrate is -20 $\mu$m to 20 $\mu$m.

Optionally, the bow of the SiC substrate is -10 $\mu$m to 10 $\mu$m.

Optionally, the crystal form of the SiC substrate is 2H-SiC, 4H-SiC, 6H-SiC, 3C-SiC, or 15R-SiC.

Optionally, the crystal form of the SiC substrate is 4H-SiC.

Optionally, the SiC substrate is a semi-insulating SiC substrate or a conductive SiC substrate.

Optionally, the local thickness deviation of the first gradient stress region is 0.1 $\mu$m to 0.3 $\mu$m, the local thickness deviation of the second gradient stress region is 0.3 $\mu$m to 0.7 $\mu$m, and the local thickness deviation of the third gradient stress region is 0.7 $\mu$m to 2 $\mu$m.

The SiC substrate described in any of the above items is made by processing a SiC single crystal. According to another aspect of the present application, a method for preparing a SiC single crystal is provided, including the following steps:

(1) adding silicon carbide powders to a graphite crucible;

(2) vacuuming the furnace to a pressure lower than $10^{-6}$ mbar, then introducing a high-purity inert gas to a pressure of 300 mbar to 500 mbar, repeating this process 2 to 3 times, and finally vacuuming the furnace to a pressure lower than $10^{-6}$ mbar;

(3) introducing the high-purity inert gas into the furnace to increase the pressure to 10 mbar to 100 mbar in 1 h to 3 h, and continuing to introduce the high-purity inert gas to maintain a constant pressure;

(4) in the crystal growth stage, under the constant pressure, raising the temperature in the furnace to the single crystal growth temperature of 2200 K to 2800 K in 3 h to 5 h, and the growth time is 30 h to 150 h; and

(5) after the single crystal growth is complete, opening the furnace and taking out the graphite crucible to obtain SiC single crystals.

Optionally, the graphite crucible is coated with a composite coating, which includes:

a $Ta_xC_y$ permeable layer, which is deposited on the graphite substrate, where $0 < x < 1$ and $0 < y < 1$; and

a TaC coating, which is coated on the $Ta_xC_y$ permeable layer.

The $Ta_xC_y$ permeable layer formed on the surface and inside of the graphite substrate is evenly distributed on the surface of the graphite substrate and has good density, improving the environmental stability of SiC crystals during growth and reducing the thermal expansion of the graphite substrate.

Optionally, the $Ta_xC_y$ grains in the $Ta_xC_y$ permeable layer grow anisotropically, the TaC grains in the TaC coating grow along the [200] and [220] directions, and the $Ta_xC_y$ grains in the $Ta_xC_y$ permeable layer and the TaC grains in the TaC coating are arranged in a staggered manner. The $Ta_xC_y$ grains in the $Ta_xC_y$ permeable layer are arranged in a staggered manner, and the size range of the $Ta_xC_y$ grains is 5 $\mu$m to 30 $\mu$m. The TaC grains in the TaC coating are arranged in a stacked and staggered manner, and the size range of the TaC grains is 15 $\mu$m to 40 $\mu$m.

The size of the $Ta_xC_y$ grains can reduce the stress in the $Ta_xC_y$ permeable layer, to avoid the formation of obvious grain boundaries in the $Ta_xC_y$ permeable layer or the generation of cracks in the $Ta_xC_y$ permeable layer, thereby avoiding the graphite substrate from squeezing the crystal.

The TaC grains in the TaC coating grow along the [200] and [220] directions, which can improve the density of the TaC coating, thereby improving the bonding strength between the composite coating and the graphite substrate, as well as the temperature resistance and thermal chemical corrosion resistance of the composite coating, and further reducing the interference of the graphite substrate with crystal growth, which is conducive to the preparation of SiC crystals with uniform quality.

Optionally, the thickness of the $Ta_xC_y$ permeable layer is 10 μm to 450 μm, the thickness of the TaC coating is 30 μm to 400 μm, and the total thickness of the $Ta_xC_y$ permeable layer and the TaC coating is 40 μm to 500 μm.

The beneficial effects of the present application include but are not limited to:

1. The stress introduced by temperature gradient change or crystal growth environment changes during SiC crystal growth is the internal stress of the SiC substrate. In the SiC substrate according to the present application, the first gradient stress region is the compressive stress zone, the second gradient stress region is the stress transition zone, and the third gradient stress region is the tensile stress zone, thereby obtaining a SiC substrate having a stepwise stress distribution.

2. The SiC substrate according to the present application has low radial and axial internal stresses in the first gradient stress region, the second gradient stress region, and the third gradient stress region, with uniform stress distributions in the zones and uniform transitions of stress at the boundaries, proving that the SiC substrate has good uniformity and can be used as an epitaxial substrate or seed crystal, which is conducive to improving the production quality of downstream products.

3. The stress values obtained in different zones of the SiC substrate according to the present application can show the changes in the lattice in different zones, and can be used to analyze the microscopic unit cell parameters of the substrate, thereby providing feedback and facilitating mass production of high-quality SiC substrates.

4. The composite coating formed on the crucible surface according to the present application can to improve the tolerance of the graphite crucible and reduce the influence of the graphite crucible on crystal growth, thereby improving the stability of the crystal environment and the uniformity of the temperature field, reducing the number of defects and impurity content in the crystal, and thus preparing high-quality SiC crystals having a stepwise stress distribution.

5. Based on stress distribution in the different zones of the SiC substrate according to the present application, the parameters of each process of crystal growth can be adjusted to prepare a high-quality SiC substrate. The stresses detected with the quantitative testing method according to the present application further include the stress that is generated from the lattice distortion in the substrate but has not been released by defects. Therefore, this method can improve the detection accuracy of stresses of the SiC substrate, and present all the stress information of the entire SiC substrate.

## BRIEF DESCRIPTION OF DRAWINGS

To illustrate technical solutions in the embodiments of the present application or in the prior art more clearly, drawings to be used for describing the embodiments or prior art are introduced briefly in the following. Obviously, the drawings in the following description are only some embodiments of the present application, and persons of ordinary skill in the art can derive other drawings from the drawings without creative efforts. In the drawings:

FIG. 1 is a schematic diagram of the internal stress of the substrate obtained by equal-interval focus testing with Raman spectroscopy in Embodiment 4 of the present application.

FIG. 2 is a schematic diagram of the internal stress of the substrate obtained by equal focal plane testing with Raman spectroscopy in Embodiment 4 of the present application.

FIG. 3 is a SEM image of the surface of crucible 1# in Embodiment 5 of the present application.

## DETAILED DESCRIPTION OF THE EMBODIMENTS

The embodiments of the present application provide a SiC substrate having a stepwise stress distribution.

In order to enable a person skilled in the art to better understand the technical solutions of the present application, the technical solutions in the embodiments of the present application will be clearly and completely described below with reference to drawings. It is evident that the embodiments described are merely part of the embodiments of the present application, rather than all embodiments. All other embodiments derived by a person of ordinary skill in the art based on the embodiments of the present application without creative efforts shall fall within the scope of protection of the present application.

The present application is described in detail below with reference to the embodiments, but the present application is not limited to the embodiments.

Unless otherwise specified, the raw materials used in the embodiments of the present application are purchased from commercial channels.

The principle of substrate stress testing with Raman spectroscopy in the following embodiments is that when a monochromatic laser light of a certain wavelength emitted from the Raman spectrometer passes through a series of optical paths, it is converged by an objective lens onto the substrate surface, where the laser photons interact with the substrate lattice, causing photon scattering. The occurrence of Raman scattering is related to the lattice vibration of the substrate itself. When there is any residual stress in the sample, the tensile or compressive stress will elongate or compress atomic bonds accordingly, resulting in a decrease or increase in the vibration frequency of atoms. This change will be reflected in the Raman spectrum as the characteristic peak of the substrate shifts toward low or high frequency, that is to say, a peak offset occurs.

Embodiment 1: Method for quantitative stress testing of substrate

(1) Calculating the conversion coefficient for conversion of peak offset to stress

First, using a single crystal XRD diffractometer to test the silicon carbide substrate, analyzing the substrate in accordance with reciprocal lattice space mapping, calculating the parameters of the standard 4H-SiC substrate, and comparing the results with the values of standard parameters. Then, according to the Bragg's equation for diffraction, namely $2d\sin\theta = n\lambda$, where d is the interplanar spacing, $\theta$ is the half-angle of diffraction, n is the order of diffraction, and $\lambda$ is the wavelength, testing the $\theta$ and d values of different substrates. It can be seen that the tensile or compressive stress in the crystal will cause expansion or contraction of the interplanar spacing d correspondingly. Based on different interplanar spacings $d_0$ and $d_x$, where $d_x$ further includes $d_1$ and $d_2$, $d_0$ is the theoretical interplanar spacing, $d_1$ is the interplanar spacing in case of tensile stress and is greater than $d_0$, and $d_2$ is the interplanar spacing in case of compressive stress and is less than $d_0$, calculating the interplanar spacing difference $\Delta d$ at different positions, where $\Delta d = d_1 - d_0$ or $\Delta d = d_0 - d_2$.

Comparing the actual peak positions of the substrate obtained by stress testing with Raman spectroscopy with the standard peak positions to calculate the peak offsets $\Delta v$ at different testing points; and based on Hooke's law or the stress-strain formula, calculating the stress values $\sigma$ of the silicon carbide substrate at different testing points, with the ratio of peak offset to stress value at different testing points being the conversion coefficient $\mu$ for conversion of peak offset to stress and the value of $\mu$ ranging from -125 to -2500.

The formula of Hooke's law is $\sigma/S = E \times (\Delta d/d0)$, where S is the area over which $\sigma$ works, and is a fixed value. When Hooke's law is applicable to microscopic calculations, S is the microscopic area, which can be taken as 1; E is the Young's modulus of the substrate, which is a fixed parameter of the substrate; $\Delta d$ is the interplanar spacing difference, which varies with different positions; d0 is the theoretical interplanar spacing; and $\sigma$ is the stress value to be calculated.

The stress-strain formula is $\sigma = E \times \Delta d$, where E is the Young's modulus of the substrate, which is a fixed parameter of the substrate; $\Delta d$ is the interplanar spacing difference, which varies with different positions; and $\sigma$ is the stress value to be calculated.

(2) Quantitative stress testing of substrate

First, setting the Raman testing points. The testing method can be single-point testing or mapping of the entire substrate. For single-point testing, setting a few scattered coordinate points. For mapping, setting $10 \times 10$ to $50 \times 50$ or more points. Selecting an appropriate test method according to the properties of the substrate, and then determining the diagram of the coordinates of the Raman testing points of the silicon carbide substrate.

Outputting the test results, including but not limited to editable peak positions, peak intensity data, and mapping.

Then, performing peak fitting on the output data with a fitting function, including but not limited to Gaussian, Lorentz, GaussLor, AGauss, Aloren, and AGaussLor, to obtain accurate peak values and peak offsets. The peak positions are accurate to more than 1 decimal place.

Finally, based on the conversion coefficient $\mu$ for conversion of peak offset to stress obtained in (1) and the peak offsets $\Delta v$ obtained in the stress testing with Raman spectroscopy, calculating the stress values of silicon carbide with the formula $\sigma$ (MPa) $= \mu \times \Delta v$ (cm$^{-1}$), and finally obtaining the stress testing images of the substrate.

Embodiment 2: Bow testing of substrate surface

Since SiC has undergone a large amount of external mechanical stress in the process of preparing wafers from crystals through a series of processing, it is difficult to ensure that the surface is completely horizontal, that is to say, there are certain degrees of bow and warp. In order to eliminate the influence of substrate surface bow on testing its surface stress and internal stress, it is necessary to first perform bow testing on the substrate. According to the degree of bow, equal-interval focus testing is used for the surface stress of the substrate, and equal-interval focus testing or equal focal plane testing is used for the internal stress of the substrate.

After bow testing, it is necessary to calibrate the tester with single crystal silicon. First, performing Z-axis mapping on a single crystal Si substrate to confirm that its peak intensity is Gaussian distribution. Taking the surface of the single crystal Si substrate as the zero point, and performing axial mapping from a position of -100 $\mu$m in the single crystal Si substrate to another position of +20 $\mu$m above the single crystal Si substrate, to analyze the change of Raman signal intensity. The single crystal Si substrate is a non-transparent material, so its peak intensity presents a Gaussian distribution with the zero point at the surface as the symmetry axis. After that, performing single-point focus testing on the surface of the single crystal Si substrate, and using a correction instrument to adjust the position of the Raman signal peak of the single crystal Si substrate to 520.70 cm-1. Then, the optical path calibration of the tester is complete.

Using the calibrated tester to perform Z-axis testing on the 4H-SiC substrate, in which the testing range of the Raman laser light is from a position of -100 $\mu$m in the 4H-SiC substrate to another position of +20 $\mu$m above the 4H-SiC substrate. The 4H-SiC substrate and other silicon carbides have the characteristics of transparent materials, so the Raman laser light can go into the silicon carbide substrate. As the depth of penetration of the Raman laser light increases, the feedback signal gradually weakens. Other silicon carbide substrates include semi-insulating SiC, conductive SiC, and different crystal forms such as 3C, 4H, 15R, and 6H. Therefore, the Raman peak intensity of the SiC substrate gradually decreases as the depth of penetration of the Raman laser light in the SiC substrate increases.

With its automatic focusing function, the Raman tester can be automatically set to find the strongest peak of the testing signal on the substrate surface, so that the substrate surface bow can be measured with this function. The specific method is as follows:

S1: First, ensuring the levelness of the test platform, selecting a fixed origin (0, 0) on the test platform, and marking this point with three-dimensional coordinates (0, 0, 0);

S2: Based on the thickness of the substrate, raising an objective lens to a height where the objective lens does not contact the substrate, performing automatic focusing at any point to the position of the strongest testing signal on the substrate surface, marking the position as (a, b, c), and then lowering the Raman laser light by a distance H, to move the position of focus to (a, b, c-H); and

S3: Adjusting the testing position of the Raman laser light to (0, 0, c-H) for equal focal plane testing to obtain a two-dimensional peak intensity scanning image of the substrate surface; according to the peak intensity distribution relationship of the silicon carbide substrate and the two-dimensional peak strength scanning diagram of the substrate surface, obtaining the distance between the focal plane of the Raman laser light and the surface of the silicon carbide substrate, thereby obtaining the in-plane bending condition of the substrate and the in-plane bow distribution diagram of the substrate.

Embodiment 3: Axial testing to distinguish between surface stress and internal stress of substrate

Since the substrate is affected by the temperature field and introduction of inclusions during crystal growth, thermal stress and residual stress exist inside the crystal. In addition, the crystal undergoes a series of cutting, grinding, and polishing to obtain the substrate, and this machining process will cause surface lattice distortion, thereby generating surface stress. In order to further distinguish between the surface stress and the internal stress of the substrate, according to the light transmittance characteristics of silicon carbide, axial testing, namely Z-axis mapping, is performed on the substrate. For the axial testing, the substrate surface is taken as the zero point, and the testing range is from a position of -150 $\mu$m to -30 $\mu$m inside the substrate to above the substrate surface.

During the test, the laser light spot gradually moves upward from the inside of the substrate to the damage stress extension layer, further to the surface damage layer, and then continues to move upward into the air. This process allows the determination of the thicknesses of the surface damage layer and the damage stress extension layer of the substrate. The substrate surface is taken as the zero point, and the range of axial testing is from a position of -100 $\mu$m in the substrate to another position of 30 $\mu$m above the substrate surface as the Raman laser light spot gradually moves upward. Five points, namely an upper point, a lower point, a left point, a right point, and a middle point are tested on the substrate. The five points show the same trend, except that the difference lies in the maximum value of negative stress at the surface damage.

When the laser light spot gradually moves up from a position of -100 $\mu$m to another position of -30 $\mu$m in the substrate, the stress fluctuates along the horizontal line, indicating that the internal stress is uniform. When the laser light spot focuses on the damage stress extension layer, the stress curve begins to show a downward trend at -30 $\mu$m, and the downward trend gradually increases. When the laser light spot approaches the zero point at the substrate surface, the negative stress reaches the maximum value, which is the stress value of the surface damage layer. Finally, the laser light spot continues to move upward and gradually leaves the substrate surface into the air, where the stress rapidly increases and exhibits turbulent fluctuations. Therefore, the thicknesses of the surface damage layer and the damage stress extension layer of the substrate can be determined according to the axial testing results of the substrate, to distinguish the stresses in the substrate into the surface stress and the internal stress, thereby providing a theoretical basis for the subsequent quantitative testing of the surface stress and the internal stress of the substrate.

Embodiment 4: Quantitative testing of internal stress of substrate

During crystal growth by physical vapor transport (PVT), silicon carbide is affected by temperature gradient changes and the introduction of unexpected inclusions, resulting in residual stress in the crystal. Unlike the surface stress due to machining, the internal stress is located at a certain depth from the surface and presents as the thermal stress of crystal growth and the residual stress. In addition, since silicon carbide has undergone a large amount of external mechanical stress in the process of preparing substrates from crystals through a series of processing, it is difficult to ensure that the surface is completely horizontal, that is to say, the substrate surface exhibits a certain degree of bow and warp. According to the method for measuring the substrate bow by stress testing with Raman spectroscopy in Embodiment 2, this embodiment, based on the physical properties of silicon carbide, relates to a method for quantitatively characterizing its internal stress without being affected by substrate bow or warp.

According to the light transmittance characteristics of silicon carbide, Raman laser light is used to quantitatively characterize the internal stress of the substrate, and the method includes equal-interval focus testing and equal focal plane testing, which are described in detail as follows:

1. Equal-interval focus testing

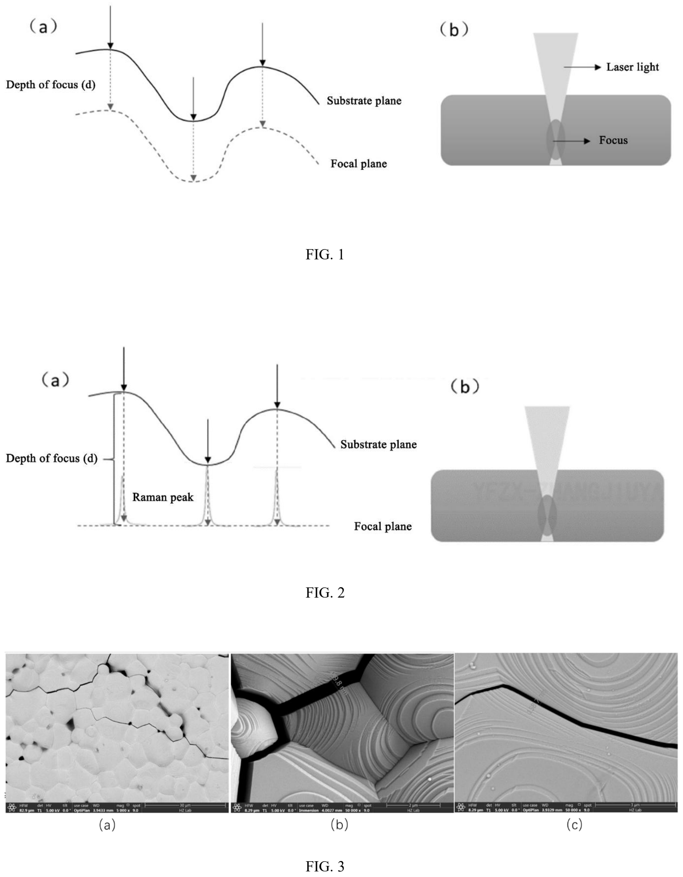

The principle of equal-interval focus testing is shown in FIG. 1. FIG. 1(b) is a schematic diagram of the focus of the Raman laser light inside the substrate, and FIG. 1(a) is a schematic diagram of the test. In this testing, the depth of focus (d) of the Raman laser light in the substrate remains unchanged at different testing points. First, the depth of penetration (Dp) of the Raman laser light is calculated with the following formula:

$$D_p = \frac{1}{\alpha} = \frac{\lambda}{4\pi k}$$

where Dp is the depth of penetration of the excited Raman laser light in the sample, $\alpha$ is the absorption coefficient, $\lambda$ is the wavelength of the laser light, and k is the extinction coefficient. Calculating the specific values of the depth of penetration (Dp) with the above formula, and selecting an appropriate depth of focus (d). It is required that the depth of penetration (Dp) shall be greater than the depth of focus (d); and since the testing target is the internal stress, the depth of focus (d) shall be greater than the thicknesses of the surface damage layer and the damage stress extension layer obtained by testing in Embodiment 3.

Then, calculating the spot diameter (D) of the Raman laser light with the following formula:

$$D = \frac{2\lambda}{N_a{}^2},$$

where $\lambda$ is the wavelength of the laser light, and Na is the numerical value of the hole diameter of the device.

The spot diameter (D) is the minor axis diameter of the laser light spot. The larger this value is, the stronger the Raman peak intensity at each testing position is and the more impurity peaks there are, which will affect the detection accuracy of Raman spectroscopy. When $\lambda$ is determined, the larger the Na value is, the weaker the peak intensity is, which will affect the detection accuracy of Raman spectroscopy too. Therefore, it is necessary to select appropriate $\lambda$ and Na values to improve the accuracy of this testing method.

According to the characteristics of silicon carbide, the peak intensity reaches the maximum value when the laser light focuses on the substrate surface. Therefore, the automatic focusing function of the Raman tester can realize focusing the laser light on the substrate surface. Then, according to the depth of focus (d) mentioned above, performing equal-interval focus testing at different positions on the substrate, that is to say, the distance between the focal plane and the substrate surface always remains the same. This method is not affected by substrate bow or warp, so that the obtained Raman peak intensity is always at the maximum axial value of the testing point. Using the quantitative stress testing method in Embodiment 1 to obtain the internal stress test diagram of the substrate.

2. Equal focal plane testing

The principle of equal focal plane testing is shown in FIG. 2. FIG. 2(b) is a schematic diagram of the focus of the Raman laser inside the substrate, and FIG. 2(a) is a schematic diagram of the test. In this test, the depth of focus (d) of the Raman laser light spot in the substrate varies at different testing points, and the laser light spot focuses on the same plane inside the substrate at different testing points. The depth of penetration (Dp) of the Raman laser is calculated with the same formula for equal spacing focusing testing, and the appropriate depth of focus (d) is selected with the same method.

Since the focal plane remains the same in this test method, considering the characteristics of silicon carbide, the peak intensity reaches its maximum value when the laser light focuses on the substrate surface and the signal gradually decays as the depth of focus increases. In addition, according to the effective signal-to-noise ratio obtained by the Raman tester, it is found that the effective signal-to-noise ratio is inversely negatively correlated with the depth of focus (d) of the Raman laser light. Therefore, in this testing method, for the depth of focus (d) at different testing points, it is necessary to combine the substrate bow to obtain the effective peak offset by using the quantitative stress testing method in Embodiment 1, thereby reducing the error of internal stress testing. This testing method will output the diagram of the internal stress testing results of the substrate.

Through equal-interval focus testing and equal focal plane testing mentioned above, the peak offsets in the substrate can be obtained respectively, and the internal stress distribution of the substrate can be calculated. The difference between the internal stress values of the substrate obtained in equal-interval focus testing and equal focal plane testing is not greater than 0.2 MPa, and the difference between the peak positions obtained in equal-interval focus testing and equal focal plane testing is smaller than $0.0005 \text{ cm}^{-1}$. The two methods mentioned above can verify the accuracy of the quantitative testing method according to the present application, and the accuracy of the testing method can be further improved by setting the depth of focus and the spot diameter.

The internal stress includes an absolute internal stress and a relative internal stress. Taking 4H-SiC as an example:

The absolute internal stress is related to the difference between the actual 4H-SiC peak position and the standard peak position in terms of peak position with a fixed reduced wave vector, such as the FTO(2/4) peak position. The calculation formula of the absolute internal stress is:

$\sigma_{absolute} = \mu \times (V_{actual} - V_{FTO(2/4)})$, where $\sigma$ is measured in MPa, $V_{actual}$ and $V_{FTO(2/4)}$ are measured in $\text{cm}^{-1}$, $V_{actual}$ is the actual FTO(2/4) peak position at the testing point of the substrate, and $V_{FTO(2/4)}$ is the standard FTO(2/4) peak position of the substrate; and

The relative internal stress is related to the difference between the actual peak positions at any two positions in the SiC substrate in terms of peak position with a same reduced wave vector, such as the FTO(2/4) peak position. The calculation formula for the relative internal stress is:

$\beta_{relative} = \mu \times (V_{(x1, y1)} - V_{(x2, y2)})$, where $\sigma$ is measured in MPa, $V_{(x1, y1)}$ and $V_{(x2, y2)}$ are measured in $\text{cm}^{-1}$, $V_{(x1, y1)}$ is the actual FTO(2/4) peak position at the testing point of the substrate, and $V_{(x2, y2)}$ is the actual FTO(2/4) peak position at the relative point of the substrate. Calculating the relative value of the stress at the testing point with the calculation formula above. If the relative value of $\sigma$ is positive, the stress at the testing point relative to the relative point is a tensile stress. If the relative value of $\sigma$ is negative, the stress at the testing point relative to the relative point is a compressive stress.

Embodiment 5

This embodiment relates to a method for preparing a graphite crucible for SiC growth, including the following steps:

(1) immersing a graphite substrate with a porosity of 5% to 55% in a tantalum pentachloride solution with a concentration of 5% to 95%, performing gas pressurization with a gas pressure of 1 MPa to 2 MPa for 0.5 h to 1 h, drying the immersed graphite substrate, and calcining the graphite substrate to obtain the graphite substrate with a $Ta_xC_y$ permeable layer; and

(2) preparing a TaC-containing slurry, which includes 25 to 40 portions of TaC powders, 20 to 35 portions of a solvent, 15 to 25 portions of a cosolvent, 1 to 3 portions of a defoamer, 2 to 5 portions of a thickener, 5 to 15 portions of linear saturated aliphatic hydrocarbons, and 1 to 3 portions of carbon powders, spraying the slurry onto the surface of the graphite substrate with the $Ta_xC_y$ permeable layer, drying, and then sintering in an inert gas atmosphere, including sintering at 700 mbar to 900 mbar and 500°C to 700°C for 3 h to 5 h; then raising the pressure to 1000 mbar to 1100 mbar, raising the temperature to 1600°C to 1800°C, and sintering for 8 h to 10 h; then raising the pressure to 145 kPa to 155 kPa, raising the temperature 2200°C to 2400°C, and sintering for 14 h to 16 h; and finally reducing the temperature and pressure to room temperature and normal pressure respectively in 15 h to 25 h, to obtain the graphite crucible.

Optionally, the calcining in step (1) is performed in an inert gas atmosphere, and the dried graphite substrate is placed in a vacuum furnace for stepwise temperature raising and stepwise temperature reduction, in which:

stepwise temperature raising: raising the temperature to 250°C to 350°C, and calcining for 4 h to 6 h; then raising the temperature to 850°C to 950°C, and calcining for 2.5 h to 3.5 h; and finally raising the temperature to 1200°C to 1300°C, and calcining for 3 h to 5 h; and

stepwise temperature reduction: reducing the temperature to 900°C to 1100°C, and holding for 0.5 h to 2 h; then reducing the temperature to 750°C to 850°C, and holding for 0.5 h to 1 h; and finally reducing the temperature to room temperature at a cooling rate of 15 °C/h to 25 °C/h.

Optionally, the pressure in the vacuum furnace during calcination is 800 mbar to 1000 mbar.

Crucibles 1# to 6# and comparative crucibles D1# to D3# were prepared with the preparation method mentioned above. The details are as follows:

Crucible 1#

(1.1) Placing a tantalum pentachloride n-butanol solution with a graphite substrate in a container, in which the concentration of tantalum pentachloride in the tantalum pentachloride n-butanol solution is 70%, and the porosity of the graphite substrate is 45%. Placing the container in a pressure chamber for pressurization treatment at a rate of 0.1 MPa/min. When the pressure in the pressure chamber reaches 1 MPa, holding the pressure for 1 h, then releasing the pressure, and transferring the soaked graphite substrate to a vacuum furnace. Drying at 60°C for 7 h, then introducing argon into the vacuum furnace to hold the pressure in the furnace at 900 mbar before calcination. Performing stepwise temperature raising, including: raising the temperature to 300°C in 1 h, and calcining for 5 h; then raising the temperature to 900°C in 2 h, and calcining for 3 h; and finally raising the temperature to 1250°C in 1 h, and calcining for 4 h. Performing stepwise temperature reduction, including: reducing the temperature to 1000°C in 1 h, and holding the temperature for 1 h; then reducing the temperature to 800°C in 1 h, and holding the temperature for 1 h; and finally reducing the temperature to room temperature at a rate of 20 °C/h, to obtain a graphite substrate with a $Ta_xC_y$ permeable layer.

(1.2) Dissolving 4N-TaC in an organic solvent to prepare a TaC-containing slurry, which includes 32.7 portions of TaC powders, 25 portions of ethanol, 20 portions of tetrahydrofuran, 1.5 portions of a BYK defoamer, 3.5 portions of cellulose ether, 10 portions of linear saturated aliphatic hydrocarbons, and 1.3 portions of carbon powders. Mixing the above components and stirring for 2.5 h. Using a spray machine to spray the slurry onto the surface of the graphite substrate with the $Ta_xC_y$ permeable layer. After spraying, placing the graphite substrate in a heating furnace, raising the temperature to 200°C in an air environment and drying for 10 h; then introducing argon gas into the heating furnace, and sintering at 800 mbar and 600°C for 4 h; then raising the pressure to 1000 mbar, raising the temperature to 1700°C, and sintering for 9 h; then raising the pressure to 150 kPa, raising the temperature to 2300°C, and sintering for 15 h; and finally reducing the temperature and pressure to room temperature and normal pressure respectively in 20 h, to obtain crucible 1#.

Crucible 2#

(2.1) Placing a tantalum pentachloride n-butanol solution with a graphite substrate in a container, in which the concentration of tantalum pentachloride in the tantalum pentachloride n-butanol solution is 70%, and the porosity of the graphite substrate is 45%. Placing the container in a pressure chamber for pressurization treatment at a rate of 0.2 MPa/min. When the pressure in the pressure chamber reaches 1 MPa, holding the pressure for 1 h, then releasing the pressure, and transferring the soaked graphite substrate to a vacuum furnace. Drying at 80°C for 5 h, then introducing argon into the vacuum furnace to hold the pressure in the furnace at 800 mbar before calcination. Performing stepwise temperature raising, including: raising the temperature to 250°C in 1 h, and calcining for 6 h; then raising the temperature to 850°C in 2 h, and calcining for 3.5 h; and finally raising the temperature to 1200°C in 1 h, and calcining for 5 h. Performing stepwise temperature reduction, including: reducing the temperature to 900°C in 1 h, and holding the temperature for 2 h; then reducing the temperature to 750°C in 1 h, and holding the temperature for 1 h; and finally reducing the temperature to room temperature at a rate of 15 °C/h, to obtain a graphite substrate with a TaxCy permeable layer.

(2.2) Dissolving 4N-TaC in an organic solvent to prepare a TaC-containing slurry, which includes 25 portions of TaC powders, 20 portions of ethanol, 25 portions of tetrahydrofuran, 3 portions of a BYK defoamer, 2 portions of cellulose ether, 15 portions of linear saturated aliphatic hydrocarbons, and 3 portions of carbon powders. Mixing the above components and stirring for 2.5 h. Using a spray machine to spray the slurry onto the surface of the graphite substrate with the TaxCy permeable layer. After spraying, placing the graphite substrate in a heating furnace, raising the temperature to 180°C in an air environment and drying for 12 h; then introducing argon gas into the heating furnace, and sintering at 700 mbar and 700°C for 3 h; then raising the pressure to 1000 mbar, raising the temperature to 1800°C, and sintering for 8 h;

then raising the pressure to 145 kPa, raising the temperature to 2400°C, and sintering for 16 h; and finally reducing the temperature and pressure to room temperature and normal pressure respectively in 25 h, to obtain crucible 2#.

Crucible 3#

(3.1) Placing a tantalum pentachloride n-butanol solution with a graphite substrate in a container, in which the concentration of tantalum pentachloride in the tantalum pentachloride n-butanol solution is 70%, and the porosity of the graphite substrate is 45%. Placing the container in a pressure chamber for pressurization treatment at a rate of 0.05 MPa/min. When the pressure in the pressure chamber reaches 2 MPa, holding the pressure for 0.5 h, then releasing the pressure, and transferring the soaked graphite substrate to a vacuum furnace. Drying at 60°C for 7 h, then introducing argon into the vacuum furnace to hold the pressure in the furnace at 1000 mbar before calcination. Performing stepwise temperature raising, including: raising the temperature to 350°C in 1 h, and calcining for 4 h; then raising the temperature to 950°C in 2 h, and calcining for 2.5 h; and finally raising the temperature to 1300°C in 1 h, and calcining for 3 h. Performing stepwise temperature reduction, including: reducing the temperature to 1100°C in 1 h, and holding the temperature for 0.5 h; then reducing the temperature to 850°C in 1 h, and holding the temperature for 0.5 h; and finally reducing the temperature to room temperature at a rate of 25 °C/h, to obtain a graphite substrate with a TaxCy permeable layer.
(3.2) Dissolving 4N-TaC in an organic solvent to prepare a TaC-containing slurry, which includes 40 portions of TaC powders, 35 portions of ethanol, 15 portions of tetrahydrofuran, 1 portion of a BYK defoamer, 5 portions of cellulose ether, 5 portions of linear saturated aliphatic hydrocarbons, and 1 portion of carbon powders. Mixing the above components and stirring for 2.5 h. Using a spray machine to spray the slurry onto the surface of the graphite substrate with the TaxCy permeable layer. After spraying, placing the graphite substrate in a heating furnace, raising the temperature to 220°C in an air environment and drying for 8 h; then introducing argon gas into the heating furnace, and sintering at 900 mbar and 500°C for 5 h; then raising the pressure to 1100 mbar, raising the temperature to 1600°C, and sintering for 10 h; then raising the pressure to 155 kPa, raising the temperature to 2200°C, and sintering for 14 h; and finally reducing the temperature and pressure to room temperature and normal pressure respectively in 15 h, to obtain crucible 3# with a composite coating.

Crucible 4#

The difference between this embodiment and the embodiment for obtaining crucible 1# lies in that in Step (4.1), no gas pressurization was performed when the graphite substrate was immersed in the tantalum pentachloride n-butanol solution, but the graphite substrate was only immersed at room temperature and normal pressure for 1 h, and then dried and calcined, with the other conditions being the same as those for obtaining crucible 1#, to obtain crucible 4#.

Crucible 5#

The difference between this embodiment and the embodiment for obtaining crucible 1# lies in that in Step (5.1), after immersion and drying, the graphite substrate was calcined in a vacuum furnace as follows: holding the pressure at 900 mbar in the furnace, and calcining for 7 h at 700°C; then calcining at 1200°C for 5 h; and then performing stepwise temperature reduction, with the other conditions being the same as those of obtaining crucible 1#, to obtain crucible 5# with a composite coating.

Crucible 6#

The difference between this embodiment and the embodiment for obtaining crucible 1# lies in that in Step (6.2), after slurry spraying and drying, the graphite substrate was sintered in a heating furnace as follows: sintering at 1000 mbar and 1200°C for 12 h; then raising the pressure to 140 kPa, raising the temperature to 2300°C, and sintering for 20 h; and finally reducing the temperature and pressure to room temperature and normal pressure respectively in 20 h, with the other conditions being the same as those of obtaining crucible 1#, to obtain crucible 6#.

Comparative crucible D1#

The difference between this comparative example and Embodiment 1 lies in that Step (D1.1) was the same as Step (1.1), and Step (D1.2) was performed with chemical vapor deposition (CVD), specifically:
(D1.2) putting the graphite substrate with the $Ta_xC_y$ permeable layer into a chemical vapor deposition furnace, vacuuming the furnace to a pressure lower than 50 Pa; then raising the temperature to 1200°C; introducing a mixed gas composed of ethane, $TaCl_5$, $H_2$, and argon as the carrier gas, into the deposition furnace at a constant flow rate, with the furnace pressure maintained at 5000 Pa, in which the molar ratio of $TaCl_5$ and ethane was controlled at 1.2:1 first to form a 50 $\mu$m

thick transition layer, and then the molar ratio of $TaCl_5$ and ethane was controlled at 3:1 to form a 60 $\mu$m thick TaC coating, to obtain comparative crucible D1#.

Comparative crucible D2#

The difference between this comparative example and the comparative example for obtaining comparative crucible D1# lies in that no Step (D2.1) was involved, and the graphite substrate was used directly in Step (D2.2). Step (D2.2) was performed with CVD to form a transition layer and a TaC coating on the graphite substrate, with the same CVD conditions as those for obtaining comparative crucible D1#, to obtain comparative crucible D2#.

Comparative crucible D3#

The difference between this comparative example and the comparative example for obtaining comparative crucible D1# lies in that no Step (D3.1) was involved, and the graphite substrate was used directly in Step (D3.2). Step (D3.2) was performed with the same conditions as those in Embodiment 1, to obtain comparative crucible D3#.

Conducting high temperature erosion and thermochemical erosion experiments on crucibles 1# to 6# and comparative crucibles D1# to D3# prepared as described above, to simulate the growth environment of the third generation semiconductor SiC crystal by PVT, for which crucibles 1# to 6# and comparative crucibles D1# to D3# were kept at 2300°C in SiC atmosphere for 100 h for erosion experiment. The experiment results are shown in Table 1:

Table 1

| Sample | Weight before experiment (g) | Weight after experiment (g) | Erosion weight loss rate (%) |
|---|---|---|---|
| Crucible 1# | 46.7103 | 46.0390 | 1.43 |
| Crucible 2# | 47.8269 | 47.3314 | 1.04 |
| Crucible 3# | 47.1923 | 46.7274 | 0.98 |
| Crucible 4# | 46.3194 | 45.5326 | 1.70 |
| Crucible 5# | 47.5247 | 46.5326 | 2.09 |
| Crucible 6# | 47.3215 | 46.4137 | 1.91 |
| Comparative crucible D1# | 47.9024 | 46.3529 | 3.23 |
| Comparative crucible D2# | 46.7247 | 45.1371 | 3.40 |
| Comparative crucible D3# | 46.7372 | 45.0261 | 3.66 |

In Table 1, Erosion weight loss rate = [(Weight before experiment - Weight after experiment)/Weight before experiment] $\times$ 100%. The results of high-temperature erosion and thermochemical erosion experiments prove that the TaC coating of this embodiment can improve the protection for the graphite substrate, and prolong the tolerance and corrosion resistance of the TaC coating, thereby extending the service life of the crucible. Performing SEM testing on crucible 1# after multiple uses. The results are shown in FIG. 3. FIG. 3(a) is the SEM diagram of a local part of the composite coating on crucible 1#, and FIG. 3(b) and FIG. 3(c) are enlarged views of a crack in FIG. 3(a). It can be seen that even though crucible 1# prepared in this embodiment has cracks after multiple uses, the crack width can be controlled within 1 $\mu$m, and no penetrating crack is formed, so that the crucible 1# can still be used to produce high-quality SiC crystals. The results of EDS mapping for characterizing the TaxCy permeable layer of the crucible mentioned above show that the TaxCy permeable layer is formed inside and on the surface of the graphite substrate, interpenetrating with the inside of the graphite substrate, so that it has a strong bonding force with the graphite substrate, thereby improving the durability of the crucible. The results of XRD testing on the TaxCy permeable layer, the TaC coating, and TaC in crucible 1# of the present application show that the TaxCy grains of the TaxCy permeable layer grew anisotropically, and the TaC grains of the TaC coating grew along the [200] and [220] directions.

The composite coating prepared in this embodiment is deposited on the surface of the graphite substrate, and can protect the graphite substrate and improve its temperature resistance and chemical corrosion resistance, thereby reducing the interference of the graphite substrate on the crystal growth environment and improving the stability of the crystal environment. The oriented growth of particles in the $Ta_xC_y$ permeable layer and the TaC coating can be controlled by calcination and sintering, thereby improving the density of the composite coating. This method can be used to prepare high-quality SiC crystals.

Embodiment 6

This embodiment relates to a method for preparing a SiC single crystal with a diameter of 150 mm, including the following steps:

(1) adding silicon carbide powders to a graphite crucible;
(2) vacuuming the furnace to a pressure lower than $10^{-6}$ mbar, then introducing a high-purity inert gas to a pressure of 300 mbar to 500 mbar, repeating this process 2 to 3 times, and finally vacuuming the furnace to a pressure lower than $10^{-6}$ mbar;
(3) introducing the high-purity inert gas into the furnace to increase the pressure to 10 mbar to 100 mbar in 1 h to 3 h, and continuing to introduce the high-purity inert gas to maintain a constant pressure;
(4) in the crystal growth stage, under the constant pressure, raising the temperature in the furnace to the single crystal growth temperature of 2200 K to 2800 K in 3 h to 5 h, and the growth time is 30 h to 150 h; and
(5) after the single crystal growth is complete, opening the furnace and taking out the graphite crucible to obtain SiC single crystals.

Adding equal amounts of silicon carbide powders to crucibles 1# to 3# and comparative crucibles D1# to D3# prepared in Embodiment 6 respectively; vacuuming the furnace to a pressure lower than $10^{-6}$ mbar, then introducing a high-purity inert gas to a pressure of 300 mbar, repeating this process 3 times, and finally vacuuming the furnace to a pressure lower than $10^{-6}$ mbar; introducing the high-purity inert gas into the furnace to increase the pressure to 30 mbar in 1 h, and continuing to introduce the high-purity inert gas to maintain a constant pressure; in the crystal growth stage, under the constant pressure, raising the temperature in the furnace to the crystal growth temperature of 2500 K in 3 h, with the growth time of 70 h; after the single crystal growth is complete, opening the furnace and taking out the graphite crucibles to obtain SiC single crystals 1# to 3# and comparative SiC single crystals D1# to D3# respectively.

The SiC single crystals 1# to 3# and comparative SiC single crystals D1# to D3# mentioned above were subjected to the same cutting, grinding, mechanical polishing, and chemical polishing to obtain SiC substrates 1# to 3# and comparative SiC substrates D1# to D3#. Then, internal stress testing was performed using the methods in Embodiment 1 to Embodiment 4. The results are shown in Table 2 and Table 3.

EP 4 717 801 A1

Table 2

| Sample | Radial relative internal stress (MPa) | | | | | | | | |
|---|---|---|---|---|---|---|---|---|---|
| | First gradient stress region | Second gradient stress region | Third gradient stress region | ΔS1 | ΔS2 | ΔS3 | ΔS4 | S1-S2 | S3-S1 |
| SiC substrate 1# | -14.3~14. 5 | -9.4~10.0 | -24.8~24. 8 | 0.6~9.8 | 1.3~21.4 | 0.5~4.7 | 0.8~19.6 | 3.3~14.5 | 3.8~22.4 |
| SiC substrate 2# | -7.2~5.9 | -4.1~4.3 | -15.7~9.1 | 2.2~4.9 | 2.4~8.2 | 1.7~4.1 | 1.8~19.6 | 2.7~7.1 | 3.3~7.1 |
| SiC substrate 3# | -6.1~5.0 | -4.4~4.2 | -15.0~6.1 | 0.2~3.1 | 0.3~4.7 | 0.2~2.7 | 0.3~4.4 | 0~5.3 | 0~5.4 |
| SiC substrate D1# | -20.8~6.3 | -6.1~7.4 | -25.7~24. 9 | 1.2~18.1 | 1.3~18.6 | 1.2~13. 7 | 1.2~17.1 | 5.1~12.6 | 5.3~18.9 |
| SiC substrate D2# | -21.2~6.4 | -7.9~8.7 | -25.2~27. 6 | 2.4~19.4 | 2.5~26.7 | 2.3~14. 6 | 2.5~19.4 | 6.3~17.9 | 8.4~25.6 |
| SiC substrate D3# | -22.7~6.0 | -5.0~6.9 | -15.7~30. 5 | 1.2~21.0 | 2.3~25.9 | 1.1~15. 7 | 1.3~20.6 | 7.5~18.5 | 11.1~27. 5 |

Table 3

| | Axial relative internal stress (MPa) | | | | | | Width of third gradient stress region (mm) | Width of second gradient stress region (mm) |
|---|---|---|---|---|---|---|---|---|
| Sample | First gradient stress region | Second gradient stress region | Third gradient stress region | ΔS5 | ΔS6 | ΔS7 | | |
| SiC substrate 1# | -19.3~19.7 | -15.7~15.2 | -24.3~24.7 | 1.4~9.6 | 1.1~9.2 | 1.4~9.9 | 30 | 39 |
| SiC substrate 2# | -12.1~13.9 | -12.4~11.6 | -12.6~14.4 | 1.3~5.2 | 1.0~3.9 | 1.7~6.1 | 21 | 50 |
| SiC substrate 3# | -11.4~11.9 | -11.9~11.1 | -12.1~13.7 | 0~3.3 | 0~2.9 | 0.1~5.7 | 2.5 | 10 |
| SiC substrate D1# | -21.2~21.3 | -15.0~14.7 | -25.8~31.3 | 3.4~12.1 | 3.3~11.6 | 3.7~15.4 | 32 | 42 |
| SiC substrate D2# | -22.4~20.6 | -15.4~18.4 | -25.5~33.4 | 4.2~12.7 | 4.4~13.2 | 5.1~16.4 | 19 | 47 |
| SiC substrate D3# | -23.0~21.7 | -18.7~19.8 | -28.2~35.7 | 4.1~14.5 | 4.0~17.8 | 4.3~20.2 | 5 | 50 |

According to the results of surface form testing for SiC substrates 1# to 3# mentioned above, the local thickness deviation of the first gradient stress region is in the range of 0.1 $\mu$m to 0.3 $\mu$m, the local thickness deviation of the second gradient stress region is within the range of 0.3 $\mu$m to 0.7 $\mu$m, and the local thickness deviation of the third gradient stress region is in the range of 0.7 $\mu$m to 2 $\mu$m.

All the stress values in Table 2 and Table 3 are relative stress values. In the present application, the positive and negative signs before a stress value represent whether the substrate is under a tensile stress or compressive stress. In the prior art, the stress state of a substrate is often described and evaluated by subtracting the minimum value from the maximum value of the above stress values. For example, the axial relative internal stress of SiC substrate 1# in the first gradient stress region is -13.3 MPa to 15.7 MPa. When this range is used to generally express the axial relative internal stress of the SiC substrate 1# in the first gradient stress region, it can also be described as a stress value of 29 MPa.

Table 2 and Table 3 above show only the data of the substrates prepared by using crucibles 1# to 3# prepared in Embodiment 5 and comparative crucibles D1# to D3#. When the same crystal growth and processing method as in Embodiment 6 is used and crucibles 4# to 8# are used to prepare SiC substrate sheets, and when absolute stress is used to characterize the parameters in Table 2 and Table 3, the following requirements can be met: the width of the third gradient stress region, which is measured inward from the edge of the substrate, shall be 2.5 mm to 30mm; the width of the second gradient stress region, which is measured inward from the inner edge of the third gradient stress region, shall be 10 mm to 50 mm; the relative internal stress in the first gradient stress region shall be greater than or equal to the relative internal stress in the second gradient stress region, and less than the relative internal stress in the third gradient stress region; the radial relative internal stress in the first gradient stress region shall be -15 MPa to 15 MPa, the radial relative internal stress in the second gradient stress region shall be -10 MPa to 10 MPa, and the radial relative internal stress in the third gradient stress region shall be -24.8 MPa to 24.8 MPa; $\Delta S1 \leq \Delta S2$, 0 MPa $\leq \Delta S1 \leq$ 10 MPa, and 0 MPa $\leq \Delta S2 \leq$ 22 MPa; $\Delta S3 \leq \Delta S4$, 0 MPa $\leq \Delta S3 \leq$ 5 MPa, and 10 MPa $\leq \Delta S4 \leq$ 20 MPa; 0 MPa $\leq$ S1 - S2 $\leq$ 14.5 MPa and 0 MPa $\leq$ S3 - S1 $\leq$ 22.5 MPa; the axial internal relative stress in the first gradient stress region shall be -20 MPa to 20 MPa, the axial internal relative stress in the second gradient stress region shall be -16 MPa to 16 MPa, and the axial internal relative stress in the third gradient stress region shall be -25 to 25 MPa, 0 MPa $\leq \Delta S5 \leq$ 10 MPa, 0 MPa $\leq \Delta S6 \leq$ 10 MPa, and 0 MPa $\leq \Delta S7 \leq$ 10 MPa; the absolute internal stress in the second gradient stress region shall be greater than or equal to the absolute internal stress in the first gradient stress region, and less than the absolute internal stress in the third gradient stress region; the radial body absolute stress in the first gradient stress region shall be -20 MPa to 5 MPa, the radial body absolute stress in the second gradient stress region shall be 5 MPa to 15 MPa, and the radial body absolute stress in the third gradient stress region shall be 15.2 MPa to 50 MPa; and the axial absolute stress in the first gradient stress region shall be -30 MPa to 10 MPa, the axial absolute stress in the second gradient stress region shall be 10 MPa to 30 MPa, and the axial absolute stress in the third gradient stress region shall be 30.2 MPa to 50 MPa.

The embodiments of the present application are described in a progressive manner. The same and similar parts between the embodiments can be referred to each other. Each embodiment focuses on the differences from other

**EP 4 717 801 A1**

embodiments. In particular, for embodiments of devices, equipment, and non-volatile computer storage medium, since they are basically similar to embodiments of a method, the description is relatively simple. Please refer to some descriptions of the method embodiments for relevant content.

Finally, it should be understood that the above embodiments of the present application are only used to illustrate the technical solution of the present disclosure, and are not intended to limit them. Although the present disclosure has been described in detail with reference to the aforementioned embodiments, those of ordinary skill in the art will appreciate that modifications can still be made to the technical solutions described in the aforementioned embodiments, or equivalents may be substituted for certain technical features. Such modifications or substitutions do not make the essence of the corresponding technical solutions depart from the spirit and scope of the technical solutions of the embodiments of the present disclosure.

**Claims**

1. A silicon carbide (SiC) substrate having a stepwise stress distribution, wherein the diameter of the SiC substrate is 150 mm or greater, and the SiC substrate comprises a first main surface and a second main surface; the first main surface has a first gradient stress region, a second gradient stress region surrounding the first gradient stress region, and a third gradient stress region surrounding the second gradient stress region; the width of the third gradient stress region, which is measured inward from the edge of the SiC substrate, is 2.5 mm to 30 mm, and the width of the second gradient stress region, which is measured inward from the inner edge of the third gradient stress region, is 10 mm to 50 mm; and a relative internal stress in the first gradient stress region is greater than or equal to a relative internal stress in the second gradient stress region, and the relative internal stress in the first gradient stress region is less than a relative internal stress in the third gradient stress region, wherein the relative internal stress is a stress value detected at a position which is at least 3 $\mu$m deep measured perpendicularly from the first main surface or second main surface into the SiC substrate.

2. The SiC substrate having a stepwise stress distribution according to claim 1, wherein an absolute internal stress in the second gradient stress region is greater than or equal to an absolute internal stress in the first gradient stress region, and the absolute internal stress in the second gradient stress region is less than an absolute internal stress in the third gradient stress region, wherein the absolute internal stress is a stress value detected at a position which is at least 3 $\mu$m deep measured perpendicularly from the first main surface or the second main surface into the SiC substrate; and/or
   at any plane parallel to the first main surface and/or the second main surface, the radial absolute internal stress value in the first gradient stress region is from -20 MPa to 5 MPa, the radial absolute internal stress value in the second gradient stress region is from 5 MPa to 15 MPa, and the radial absolute internal stress value in the third gradient stress region is from 15.2 MPa to 50 MPa.

3. The SiC substrate having a stepwise stress distribution according to claim 2, wherein, when axial testing is performed perpendicularly from any point on the first main surface into the SiC substrate, the axial absolute stress value in the first gradient stress region is from -30 MPa to 10 MPa, the axial absolute stress value in the second gradient stress region is from 10 MPa to 30 MPa, and the axial absolute stress value in the third gradient stress region is from 30.2 MPa to 50 MPa.

4. The SiC substrate having a stepwise stress distribution according to claim 1, wherein, at any plane parallel to the first main surface and/or the second main surface, the radial relative internal stress value in the first gradient stress region is from -15 MPa to 15 MPa, the radial relative internal stress value in the second gradient stress region is from -10 MPa to 10 MPa, and the radial relative internal stress value in the third gradient stress region is from -24.8 MPa to 24.8 MPa.

5. The SiC substrate with a stepwise stress distribution according to claim 1, wherein, at any plane parallel to the first main surface and/or the second main surface, $S_{max1}$ represents the maximum absolute value of the radial relative internal stress in the first gradient stress region, $S_{max2}$ represents the maximum absolute value of the radial relative internal stress in the second gradient stress region, and $S_{max3}$ represents the maximum absolute value of the radial relative internal stress in the third gradient stress region, in which $\Delta S1 = S_{max1} - S_{max2}$, $\Delta S2 = S_{max3} - S_{max1}$, and $\Delta S1 \leq \Delta S2$.

6. The SiC substrate having a stepwise stress distribution according to claim 5, wherein 0 MPa $\leq \Delta S1 \leq$ 10 MPa and 0 MPa $\leq \Delta S2 \leq$ 22 MPa.

17

**7.** The SiC substrate having a stepwise stress distribution according to claim **1,** wherein, at any plane parallel to the first main surface and/or the second main surface, $S_{min1}$ represents the minimum absolute value of the radial relative internal stress in the first gradient stress region, $S_{min2}$ represents the minimum absolute value of the radial relative internal stress in the second gradient stress region, and $S_{min3}$ represents the minimum absolute value of the radial relative internal stress in the third gradient stress region, in which $\Delta S3 = S_{min1} - S_{min2}$, $\Delta S4 = S_{min3} - S_{min1}$, and $\Delta S3 \leq \Delta S4$.

**8.** The SiC substrate having a stepwise stress distribution according to claim 7, wherein $0\ MPa \leq \Delta S3 \leq 5\ MPa$ and $10\ MPa \leq \Delta S4 \leq 20\ MPa$.

**9.** The SiC substrate having a stepwise stress distribution according to claim 1, wherein, at any plane parallel to the first main surface and/or the second main surface, S1 represents the average absolute value of the radial relative internal stress in the first gradient stress region, S2 represents the average absolute value of the radial relative internal stress in the second gradient stress region, and S3 represents the average absolute value of the radial relative internal stress in the third gradient stress region, in which $0\ MPa \leq S1 - S2 \leq 14.5\ MPa$ and $0\ MPa \leq S3 - S1 \leq 22.5\ MPa$.

**10.** The SiC substrate having a stepwise stress distribution according to claim 1, wherein, when axial testing is performed perpendicularly from any point on the first main surface into the SiC substrate, the axial relative internal stress value in the first gradient stress region is from -20 MPa to 20 MPa, the axial relative internal stress value in the second gradient stress region is from -16 MPa to 16 MPa, and the axial relative internal stress value in the third gradient stress region is from -25 MPa to 25 MPa.

**11.** The SiC substrate having a stepwise stress distribution according to claim 10, wherein, when axial testing is performed perpendicularly from any point on the first main surface into the SiC substrate, $S_{max5}$ represents the maximum axial relative internal stress in the first gradient stress region, and $S_{min5}$ represents the minimum axial relative internal stress in the first gradient stress region, in which $\Delta S5 = S_{max5} - S_{min5}$ and $0\ MPa \leq \Delta S5 \leq 10\ MPa$;

$S_{max6}$ represents the maximum axial relative internal stress in the second gradient stress region, and $S_{min6}$ represents the minimum axial relative internal stress in the second gradient stress region, in which $\Delta S6 = S_{max6} - S_{min6}$ and $0\ MPa \leq \Delta S6 \leq 10\ MPa$; and
$S_{max7}$ represents the maximum axial relative internal stress in the third gradient stress region, and $S_{min7}$ represents the minimum axial relative internal stress in the third gradient stress region, in which $\Delta S7 = S_{max7} - S_{min7}$ and $0\ MPa \leq \Delta S7 \leq 10\ MPa$.

**12.** The SiC substrate having a stepwise stress distribution according to claim 1, wherein the diameter of the SiC substrate is greater than 200 mm, the width of the third gradient stress region, which is measured inward from the edge of the substrate, is 21 mm to 30 mm, and the width of the second gradient stress region, which is measured inward from the inner edge of the third gradient stress region, is 10 mm to 39 mm; and/or the thickness of the SiC substrate is not less than 0.1 mm.

FIG. 1

FIG. 2

FIG. 3

## INTERNATIONAL SEARCH REPORT

| International application No. |
| --- |
| **PCT/CN2024/094999** |

| A. | CLASSIFICATION OF SUBJECT MATTER |
| --- | --- |
| | C30B23/02(2006.01)i; C30B23/06(2006.01)i |

According to International Patent Classification (IPC) or to both national classification and IPC

| B. | FIELDS SEARCHED |
| --- | --- |

Minimum documentation searched (classification system followed by classification symbols)

IPC:C30B

Documentation searched other than minimum documentation to the extent that such documents are included in the fields searched

Electronic data base consulted during the international search (name of data base and, where practicable, search terms used)

CNTXT; VEN; CJFD; CNKI; ENTXT; PATENTICS: 超星读秀, CHAOXING DUXIU; 万方, WANFANG; ISI-Web of Science: 上海天岳半导体材料, 应力, 阶梯, 梯度, 第一, 第二, 宽度, 直径, 延伸, 小于, 大于, 坩埚, 碳化硅, SiC, 涂层, 碳化钽, TaC, coating+, tantalum carbide, stress, strain, tension, gradient, step, ladder+, first, second, width, diameter, crucible, greater than, less than

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 7268784 B1 (RESONAC HOLDINGS CORP.) 08 May 2023 (2023-05-08) description, paragraphs [0030]-[0035], and figure 2 | 1-12 |
| A | CN 113652749 A (SICC CO., LTD.) 16 November 2021 (2021-11-16) entire document | 1-12 |
| A | CN 113652750 A (SICC CO., LTD.) 16 November 2021 (2021-11-16) entire document | 1-12 |
| A | CN 113957533 A (SICC CO., LTD.) 21 January 2022 (2022-01-21) entire document | 1-12 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **09 August 2024** | **28 August 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/094999**

| Patent document cited in search report | | | Publication date (day/month/year) | Patent family member(s) | | | Publication date (day/month/year) |
|---|---|---|---|---|---|---|---|
| JP | 7268784 | B1 | 08 May 2023 | US | 2024093406 | A1 | 21 March 2024 |
| | | | | JP | 2023177253 | A | 13 December 2023 |
| | | | | JP | 2023176670 | A | 13 December 2023 |
| | | | | US | 2023383438 | A1 | 30 November 2023 |
| | | | | US | 11866846 | B2 | 09 January 2024 |
| | | | | KR | 102610099 | B1 | 05 December 2023 |
| | | | | EP | 4286567 | A1 | 06 December 2023 |
| | | | | TW | 202348848 | A | 16 December 2023 |
| | | | | CN | 117144472 | A | 01 December 2023 |
| | | | | KR | 20230169018 | A | 15 December 2023 |
| CN | 113652749 | A | 16 November 2021 | CN | 113652749 | B | 12 July 2022 |
| CN | 113652750 | A | 16 November 2021 | CN | 113652750 | B | 12 July 2022 |
| CN | 113957533 | A | 21 January 2022 | CN | 113957533 | B | 27 October 2023 |

Form PCT/ISA/210 (patent family annex) (July 2022)

**REFERENCES CITED IN THE DESCRIPTION**

**Patent documents cited in the description**

- CN 202310837065